# EUROPÄISCHE PATENTSCHRIFT

(11) **EP 0 689 251 B1**
(45) Veröffentlichungstag und Bekanntmachung des Hinweises auf die Patenterteilung: **24.06.1998**
(21) Anmeldenummer: 95105081.4
(22) Anmeldetag: 05.04.1995
(51) Int. Cl.: H01L 29/861

(54) **Schnelle Leistungsdiode**
Quick power diode
Diode de puissance rapide

(30) Priorität: 20.06.1994 DE 4421529
(43) Veröffentlichungstag der Anmeldung: 27.12.1995
(73) Patentinhaber: SEMIKRON ELEKTRONIK GMBH, 90253 Nürnberg (DE)
(72) Erfinder: Lutz, Josef, Dipl. Phys., D-90443 Nürnberg (DE); Müller, Heinz-Jürgen, D-90425 Nürnberg (DE); Kinne, Marianne, D-90518 Altdorf (DE)

(56) Entgegenhaltungen:
- EP-A- 0 350 816
- DE-A- 4 310 444
- PATENT ABSTRACTS OF JAPAN vol. 17 no. 453 (E-1417) ,19.August 1993 & JP-A-05 102161 (TOSHIBA CORP) 23.April 1993,
- PATENT ABSTRACTS OF JAPAN vol. 16 no. 389 (E-1250) ,19.August 1992 & JP-A-04 127577 (NEC CORP) 28.April 1992,

## Beschreibung

Die Erfindung betrifft eine schnelle Leistungsdiode mit einem weichen Schaltverhalten für einen ein schaltbares Bauelement aufweisenden Kommutierungszweig nach den Merkmalen des Oberbegriffes des Anspruches 1.

Freilaufdioden zur Erzielung kleiner Rückstromspitzen bei der Kommutierung und weichem Rückstromabfall nach dem Maximum der Rückstromspitze und deren Herstellungsverfahren sind mehrfach in der Literatur beschrieben.

Aus EP-A-0 350 816 ist es bekannt das Recovery-Verhalten einer schnellen Leistungsdiode durch Dotierung mit Platin zu Verändern.

Anders sind die Verhältnisse bei Freilaufdioden für hohe Sperrspannungen von 1600 bis 2000 Volt. Hier wird eine Zwischenkreisspannung von mindestens 1200 Volt angestrebt. Überträgt man das in EP-A-0 350 816 genannte Verfahren nach bekannten Regeln auf beispielhaft 1600 Volt, so tritt bei Raumtemperatur, steiler Kommutierung und hoher Zwischenkreisspannung ein starker dynamischer Avalanche- Effekt auf, der das Bauelement gefährdet.

Ebenfalls berichtet die Veröffentlichung von A. Porst, "Ultimate Limits of an IGBT (MCT) for High Voltage Applicants in Conjunction with a Diode" (Proc. of the 6th ISPSD, Davos Mai 94), die unter anderem Freilaufdioden für hohe Zwischenkreisspannungen behandelt, von starken dynamischen Avalanche- Effekten bei 150°C und von dadurch hervorgerufener Zerstörung der Freilaufdioden. Daher muß die Steilheit bei der Kommutierung gesenkt werden, was aber zu höheren Verlusten führt. Nach dem Stand der Technik ist keine befriedigende Lösung für eine Freilaufdiode für die beschriebenen Anforderungen bekannt. Bekannt ist, daß für die Eigenschaften von Freilaufdioden Art und Verhalten der Rekombinationszentren wesentlich sind.

Die Dotierung mit Gold als Rekombinationszentrum zur Einstellung der Trägerlebensdauer besitzt den Vorteil, im Durchlaßzustand einen niedrigen Spannungsabfall zu bewirken. Gleichzeitig jedoch wirkt Gold als starkes Generationszentrum bei erhöhter Sperrschichttemperatur, was bei den Konzentrationen, wie sie für Freilaufdioden notwendig sind, zu einem sehr hohen Sperrstrom führt, so daß bei Spannungen > 1000 Volt solcherart gebildeter Dioden im Sperrichtung instabil werden.

Die Dotierung mit Platin führt nur zu einer schwachen Erhöhung des Sperrstromes und ist somit auch für Bauelemente > 1000 Volt geeignet, führt jedoch bei Raumtemperatur zu einer höheren Durchlaßspannung. Bei höherer Temperatur nimmt in einer solchen Freilaufdiode die gespeicherte Ladung stark zu. Es ist sehr schwierig, in diesem Fall den bei hoher Zwischenkreisspannung auftretenden Effekt des dynamischen Avalanche zu vermeiden.

Der Effekt des dynamischen Avalanche wird in einem Artikel "Limitation for the softness of fast rectifier diodes" (Proceedings PCIM 1991) beschrieben. Er tritt gerade bei Dioden mit sehr weichem Schaltverhalten auf.

Die Vor- und Nachteile der Bestrahlungsverfahren zur Veränderung der Rekombinationszentren wurden in genannten früheren eigenen Veröffentlichungen beschrieben. Insbesondere die Bedeutung der axial unterschiedlichen Konzentration der Störstellen wurde diskutiert. Bei höheren Zwischenkreisspannungen treten in Kombination mit einer Elektronenbestrahlung zur Einstellung der Grundlebensdauer bei Raumtemperatur Probleme mit der dynamischen Avalanche auf.

Die Aufgabe dieser Erfindung besteht darin, eine auch für Zwischenkreisspannungen größer 1200 Volt und sehr steiler Kommutierung geeignete Freilaufdiode darzustellen, die neben dem bekannten weichen Schaltverhalten eine möglichst geringe Temperaturabhängigkeit der Speicherladung, und sowohl bei Raumtemperatur, als auch bei 150°C stabil gegen den dynamischen Avalanche- Effekt ist.

Die Lösung der Aufgabe wird bei einer Leistungsdiode der eingangs genannten Art durch die Maßnahmen des kennzeichnenden Teiles des Anspruches 1. erreicht, vorteilhafte Ausgestaltungen sind in den Unteransprüchen angegeben. Ansprüche 6 bis 8 betreffen ein Verfahren zur Herstellung einer solcher Leistungsdiode.

Durch experimentelle Untersuchungen wurde herausgefunden, daß für die Beherrschung des dynamischen Avalanche die Art der Rekombinationszentren am n/n⁺- Übergang und die Temperaturabhängigkeit ihrer Wirkung entscheidend ist.

Über unterschiedliche Temperaturabhängigkeiten des Wirkungsquerschnittes verschiedener Rekombinationszentren konnte in der Literatur keine aufschlußreiche Aussage gefunden werden. Dabei hat es sich herausgestellt, daß die Beherrschung dieses Parameters für die Funktionsfähigkeit einer Freilaufdiode für diese Anforderungen gerade entscheidend ist.

Zunächst sollen schematisch die Vorgänge in einer Freilaufdiode bei steiler Kommutierung in der Phase nach dem Rückstrommaximum I_{RM} veranschaulicht werden.

Bei Freilaufdioden mit dem geforderten und erforderlichen weichen Schaltverhalten bei der Kommutierung steht nach Aufnahme der angelegten Zwischenkreisspannung noch ein Ladungsträgerberg in der Zone des Überganges der n- Schicht zur n⁺- Schicht an, dessen Abbau zu einem weiteren Fließen des Stromes führt, der seinerseits sanft abklingt.

Dioden mit einem geringen Ladungsträgerberg (bzw. sehr starker Rekombination) an diesem n/n⁺ Übergang besitzen ein snappiges, also hartes Schaltverhalten.

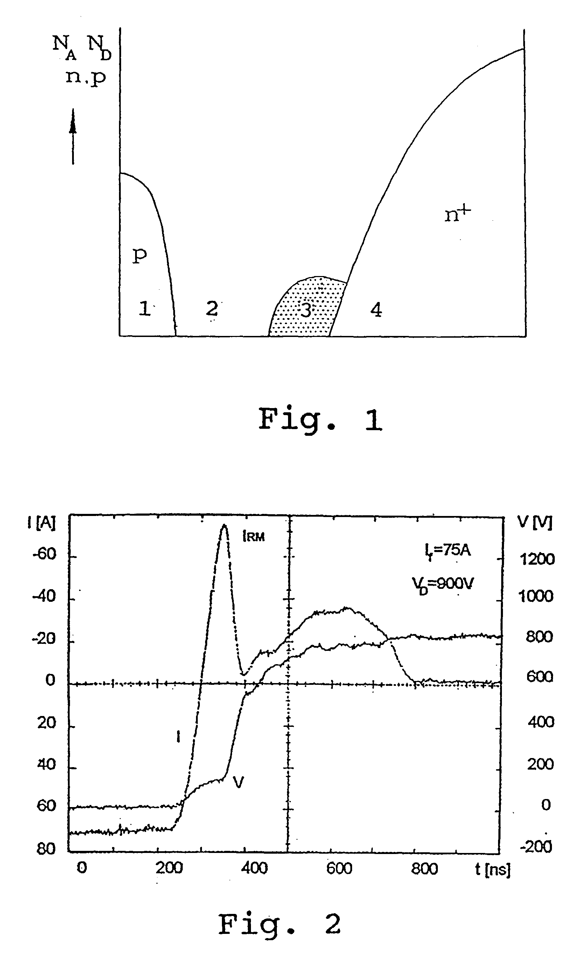

**Fig. 1** veranschaulicht diese Aussagen. In Diagrammform ist auf der Abzisse die Eindringtiefe einer allgemeinen Freilaufdiode dargestellt. Auf der Ordinate sind die Konzentrationen der Ladungsträger im logarithmischen nicht bezeichneten Maßstab symbolisiert.

Der Diagrammbezirk 1 stellt die p- Zone der Diode dar. Der Bezirk 2 trägt die Grunddotierung des gewählten Ausgangsmateriales, daß zu der Einstellung der gewünschten Trägerlebensdauer beispielsweise mit Elektronen bestrahlt wurde. Mit dem Diagrammbezirk 3 ist der Ladungsträgerberg in halbquantitativer Weise veranschaulicht, wobei diese Größe einer soften Diode zugeordnet werden kann. Der Bezirk 4 schließlich beinhaltet die stark dotierte n⁺ Seite der Diode.

Für die Ausbildung der Raumladungszone steht das Volumen der dynamischen Weite der n- Zone (Bezirk 2) bis zur Grenze des Ladungsträgerberges (Bezirk 3) zur Verfügung. Ein zu hoher Ladungsträgerberg, bzw. eine zu schwache Rekombination in diesem Ladungsträgerberg, kann zu unbeherrschbarem dynamischen Avalanche führen.

Fig. 1 zeigt gleichzeitig schematisch im Bereich 1 und 4 das Dotierungsprofil für die im folgenden beschriebenen Freilaufdioden. Es weist einen flachen Gradienten am n/n⁺- Übergang auf.

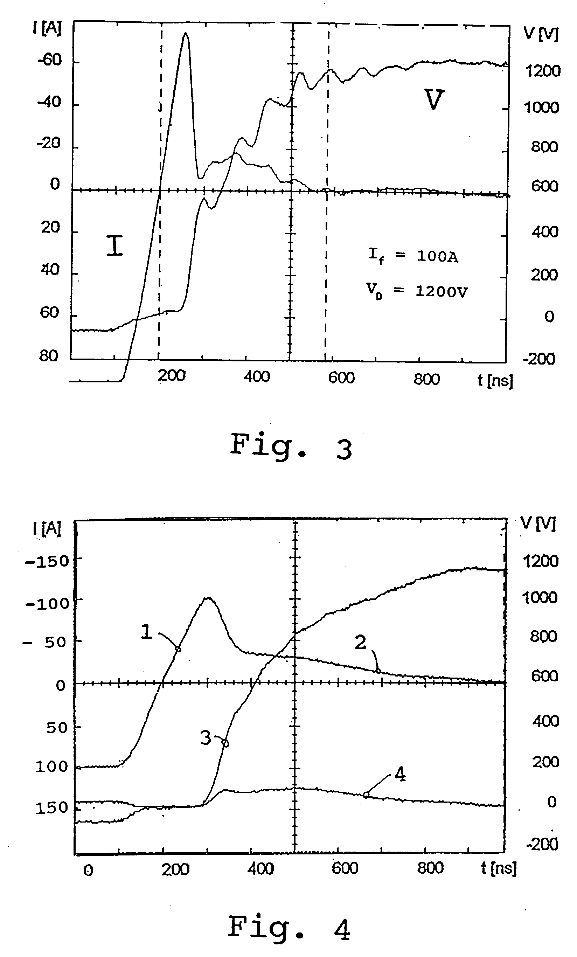

In **Fig. 2** sind die Strom- und Spannungsverläufe als Mitschrift des Oszillogrammes im Zeitpunkt der Kommutierung einer Freilaufdiode mit dem Effekt eines starken dynamischen Avalanche dargestellt. Der einwandfrei durch Generation von Ladungsträgern sichtbare "Bauch" im entscheidenden Kurvenverlauf tritt bei einer Diode bei Raumtemperatur auf, deren Trägerlebensdauer mit Elektronenbestrahlung eingestellt worden war.

Bei dieser an sich für 1600 Volt statische Sperrspannung geeigneten Freilaufdiode tritt ab einer Zwischenkreisspannung von 870 Volt nach dem Rückstrommaximum I_{RM} ein zweites Maximum auf, das durch den dynamischen Avalanche verursacht wird. Dieser "Bauch" nimmt mit der Zwischenkreisspannung zu und führt bei weiterer Spannungserhöhung zur Zerstörung des Bauelementes.

Mit solcher Diode werden bei Raumtemperatur keine 1200 Volt Zwischenkreisspannung erreicht, bei Arbeitstemperaturen der Diode oberhalb von 50°C beginnt der "Baucheffekt" abzunehmen. Der Vorgang ist temperaturabhängig mit "Bauch" bei Messungen kleiner 50°C und ohne "Bauch" bei Temperaturen oberhalb 50°C wiederholbar.

**Fig. 3** zeigt ein der Fig. 2 analog aufgenommenes Oszillogramm. Basis für die Messung ist hier eine identisch mit dem Meßobjekt der Fig. 2 hergestellte Diode, nur wurde diese Diode statt einer Elektronenbestrahlung einer Platindiffusion zur Einstellung der Trägerlebensdauer unterzogen und die Parameter der Diffusion wurden so gewählt, daß die Durchlaßspannungswerte beider Dioden bei Raumtemperatur vergleichbar sind. Die Prüfparameter sind vergleichbar. Die Zwischenkreisspannung konnte auf 1200 Volt gesteigert werden, ohne daß ein "Bauch" auftritt.

Wählt man jedoch die Arbeitstemperatur von 150°C, so weist die mit Platin diffundierte Diode aus Fig. 3 nach dem Rückstrom- Maximum ein sehr langsames Abklingen des Stromes auf. Das ist in **Fig. 4** dargestellt. Nach dem in ca. 150ns abgeschlossenen eigentlichen Kommutierungsvorgang (Kurvenverlauf 1) schließt sich ca. 500ns lang ein Tailstrom (Kurvenbereich 2) an, der langsam von 35A ausgehend abklingt und beträchtliche Verluste verursacht. Der Kurvenverlauf 3 zeigt die Spannung in der zeitlichen Folge bei der Kommutierung an, während der Kurvenverlauf 4 das Produkt aus Strom und Spannung zum jeweiligen Zeitpunkt darstellt. Beschreibt man vergleichsweise die Diode aus Fig. 2 unter diesen Bedingungen, so weist sie einen niedrigeren und sehr viel kürzeren Tailstrom auf, der bereits nach 250ns abgeklungen ist.

Das bedeutet, daß die Wirkung der Rekombinationszentren am n/n⁺- Übergang Übergang bei der mit Platin diffundierten Diode (Fig. 3) bei Raumtemperatur ausreicht, um den dynamischen Avalanche im beherrschbaren Rahmen zu halten, bei 150°C ist die Wirkung vergleichsweise schwach. Bei der mit durch Elektronenbestrahlung erzeugten Rekombinationszentren versehen Probe (Fig. 2) reicht bei Raumtemperatur die Wirkung der Rekombinationszentren nicht aus, bei 150°C ist die Wirkung vergleichsweise stark.

Das durch Platin und das durch Elektronenbestrahlung hervorgerufene Rekombinationszentrum zeigt offensichtlich verschiedene Wirkungen in der Abhängigkeit von der Temperatur. Ein gleiches temperaturbedingtes Verhalten ist bezüglich der Durchlaßspannung sichtbar.

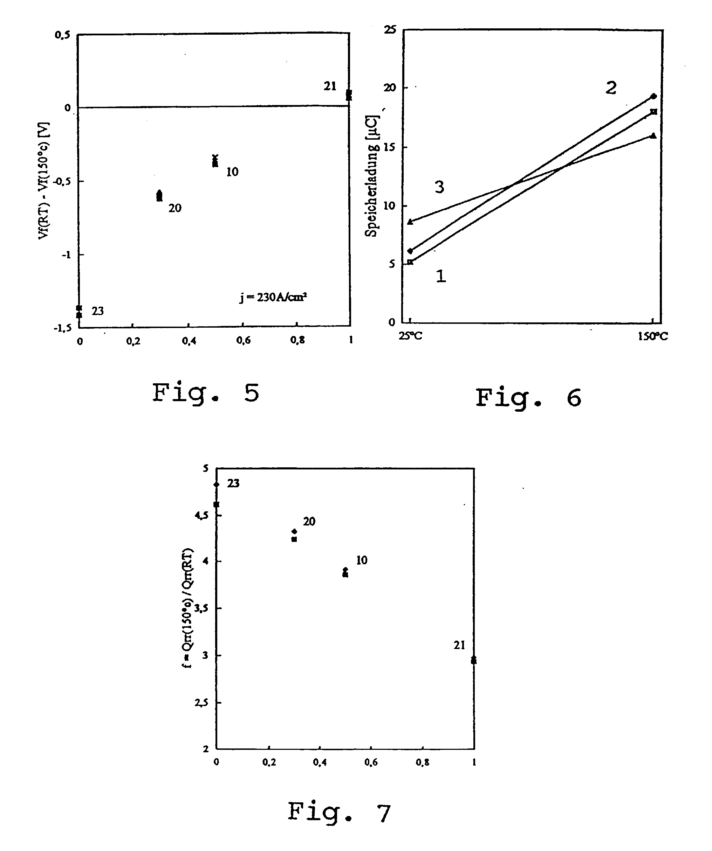

**Fig. 5** zeigt ein Diagramm mit einer Aussage über die Temperatur- Koeffizienten (Ordinate) bei der Durchlaßspannung in Abhängigkeit von der Art der gebildeten Rekombinationszentren in der Umgebung des Überganges der n- Schicht zur n⁺- Zone (Abzisse: Anteil der Elektronenbestrahlung an der Rekombination). Ein negativer Wert der Ordinate bedeutet eine Abnahme der Durchlaßspannung bei Temperatursteigerung, ein positiver Wert hingegen eine Zunahme.

Es wurden vier Arten der Prüflinge aufgebaut und gemessen. Auf der linken Ordinate findet man die Ergebnisse von Elementen (23), die nur mit Platin diffundiert waren (die gleichen, deren Schaltverhalten in Fig. 3 dargestellt ist). Auf der rechten Ordinate befinden sich die Ergebnisse (21), wie sie mittels elektronenbestrahlten Proben gemessen werden. In der Diagrammitte sind die Ergebnisse der Dioden- Muster (10, 20) enthalten, in denen bei der Präparation beide Methoden, die Platin-Diffusion und die Elektronen-bestrahlung, in solch einer Weise quantitativ kombiniert angewandt wurden, daß der Anteil der Elektronenbestrahlung an der Rekombination ca. 30% bzw.50% beträgt. Die Durchlaßspannung ist bei allen Prüfungen in Fig. 5 bei einer Stromdichte von j = 230 A/cm² und 150°C auf den selben Bereich eingestellt.

Die Zunahme der Durchlaßspannung bei der mit Elektronen bestrahlten Probe bei Temperatursteigerung zeigt, daß hier das Rekombinationszentrum bei Temperatursteigerung in seiner Wirkung stark zunimmt, obwohl mehr Ladungsträger im Halbleitervolumen bei höherer Temperatur vorhanden sind, sinkt die Leitfähigkeit.

Die starke Abnahme der Durchlaßspannung in der mit Platin diffundierten Diode zeigt, daß mehr Ladungsträger vorhanden sind und die Leitfähigkeit zunimmt, was eigentlich bei einer Diode und bei diesen Stromdichten zu erwarten ist.

Weiterhin zeigt Fig. 5, daß diese Ergebnisse genutzt werden können, durch eigene Wahl der Prozeßparamter einen gewünschten Temperaturkoeffizienten in diesem Bereich einzustellen. Das ist von großer Bedeutung für die Dimensionierung moderner Leistungshalbleiter, deren Temperaturkoeffizienten aufgrund der notwendigen Schaltung im Parallelbetrieb möglichst klein, im günstigsten Falle positiv sein sollen.

**Fig. 6** stellt schließlich in Diagrammform die Abhängigkeit der Speicherladung von der Temperatur dar. Auf der Abzisse sind die beiden relevanten Temperaturen, Raumtemperatur und 150°C, markiert, auf der Ordinate ist die Speicherladung ersichtlich.

Die Messung erfolgte unter Anwendungsnahen Bedingungen bei einer Zwischenkreisspannung von 1200 Volt. Bei Dioden mit einer Platindiffusion zur Einstellung der Trägerlebensdauer (Linien 1 und 2) verdreifacht sich die Speicherladung bei Übergang von Raumtemperatur auf 150°C. Die ausschließlich durch Elektronen-Bestrahlung zur Einstellung der Trägerlebensdauer behandelte Dioden ließen sich unter den angegebenen Meßbedingungen nicht betreiben, da bei Raumtemperatur der beschriebene parasitäre Effekt des dynamischen Avalanche auftrat.

Bei einer kombinierten Einstellung der Trägerlebensdauer mittels Elektronenbestrahlung und Platindiffusion nimmt die Speicherladung vergleichsweise um weniger als das Doppelte zu (Linie 3) und sie liegt bei 150°C niedriger als bei der alleinigen Anwendung der Platindiffusion.

Entsprechend der Aufgabenstellung dieser Erfindung war eine möglichst niedrige Speicherladung bei einem minimalen Temperaturgang gewünscht. Wie Linie 3 der Fig. 6 zeigt, ist der erfinderische überraschende Effekt durch die Kombination der zwei an sich bekannten Verfahren zur Einstellung der Trägerlebensdauer erreicht worden.

**Fig. 7** zeigt wiederum die Abhängigkeit der Speicherladung von der Temperatur bei verschiedener Zusammensetzung der Rekombinationszentren am n/n⁺- Übergang, allerdings erfolgte die Messung an einem konventionellen Speicherladungs- Meßgerät bei 400 V, 100 A und einer Kommutierung von 100 A/µs. Hier treten noch keine Effekte des dynamischen Avalanche auf und auch die elektronenbestrahlte Probe konnte über den gesamten Temperaturbereich gemessen werden. Auf der Ordinate ist aufgetragen, um wieviel sich die Speicherladung Qᵣᵣ beim Übergang auf 150°C vervielfacht. Mit der Zunahme des Anteiles der Elektronenbestrahlung ist eine deutliche Abnahme erkennbar. Die Ergebnisse korrelieren sehr gut mit den Ergebnissen, wie sie in Fig. 5 dargestellt sind.

Die Fig. 5, 6 und 7 enthalten Meßergebnisse, wie sie aus Proben resultieren, die mit kombinierten Rekombinationszentren am n/n⁺- Übergang ausgebildet worden waren.

Der Effekt des dynamischen Avalanche bei Raumtemperatur ist nicht mehr in störender Weise vorhanden, wenn auch nur ein Teil der Rekombinationszentren durch Platinatome gebildet wird. In Fig. 5, Diodentyp 10, sind beide Verfahren zu etwa 50% an der Senkung der Trägerlebensdauer beteiligt und die Neigung zu "Bäuchen" ist nicht mehr vorhanden.

Erfindungsgemäße Freilaufdioden für hohe Zwischenkreisspannungen werden zur Einstellung der Trägerlebensdauer einen Teilbeitrag durch Platinatomen in den Rekombinationszentren aufweisen, um den Effekt des dynamischen Avalanche zu vermeiden. Dieser Teilbeitrag Platin sollte möglichst gering gehalten werden, um den geringstmöglichen negativen Temperaturkoeffizienten der Durchlaßspannung zu erreichen.

Eine ausschließliche Platindiffusion erbringt keine optimalen Einsatzparameter für Freilaufdioden, da der Temperaturkoeffizient der Durchlaßspannung zu stark negativ und die Speicherladung bei 150°C zu hoch ist, was seinerseits sehr große Schaltverluste verursacht und in sich die Gefahr des dynamischen Avalanche bei diesen Bedingungen in sich birgt.

Nach den Erkenntnissen dieser Erfindung sind zusätzlich zu dem Beherrschen der Paramter an dem pn- Übergang der Freilaufdiode, die zum Stand der Technik gehören, für optimierte Freilaufdioden in gleicher Wichtigkeit die Vorgänge an der Übergangsstelle der n- Zone zum n⁺- Gebiet zu steuern.

Die Herstellung einer erfindungsgemäßen Freilaufdiode ist beispielhaft durch die Kettung der nachfolgend dargestellten Verfahrensschritte möglich:

Nach der Wahl des für hochsperrende Dioden geeigneten Ausgangsmateriales erfolgt die Ausbildung des pn- Überganges und der übrigen durch Diffusion erzeugten Dotierstoffgebiete nach dem Stand der Technik. Unmittelbar darauffolgend wird eine Platindiffusion bei einer Temperatur zwischen 820 und 900°C durchgeführt, hierbei ist die dotierte Menge an Platin den Erfordernissen der späteren Trägerlebensdauer genau anzupassen.

Nach der letzten Diffusion werden sodann alle Passivierungs- und Metallisierungsprozesse durchgeführt. Nach diesen Arbeitsschritten werden durch Implantation von Protonen oder He⁺⁺- Ionen die Eigenschaften zur Erzielung des erforderlichen soft-recovery- Verhaltens eingestellt, gemäß Anspruch 5.

Zur Steuerung der erfindungsgemäßen Parameter wurden die folgenden Verfahrensvorschriften beachtet:

**Tabelle 1**

| **Probe** (Wafer) | **Pt-Diff.** (Temp.) | **Elektronen-Bestrahlung** (Dosis) | **Vf (100A,150°C)** (Volt) |
|---|---|---|---|
| 23 | T1 + 30 | ./. | 2,73 - 2,78 |
| 20 | T1 + 15 | D 1 | 2,66 - 2,73 |
| 10 | T1 | 1,2 X D1 | 2,51 - 2,57 |
| 21 | ./. | 2 X D1 | 2,77 - 2,79 |

Zur Bewertung wurde in der Tabelle 1 der Spannungsabfall der Diode in Durchlaßrichtung (Vf) herangezogen.

Anstelle der He⁺⁺- Implantation können auch andere Verfahren zur Einstellung eines soft-recovery-Verhaltens eingesetzt werden.

Mittels Elektronenbestrahlen mit einer Energie zwischen 1 MeV und 8 MeV und einer Dosis zwischen 100 KGy und 180 KGy wird die Trägerlebensdauer endgültig eingestellt. Durch Ausheilen bei Temperaturen oberhalb der späteren Lötverarbeitung werden die in den Diodenkörper eingebrachten Störstellen fixiert und stabilisiert.

Das umrissene Verfahren, unterschiedliche Rekombinationszentren mit unterschiedlichen Temperaturabhängigkeiten in einen Halbleiterkörper einzubringen, ist analog der Anwendung bei Freilaufdioden auch bei anderen Halbleiterbauelementen anwendbar. Bipolare Transistoren, MOSFET- Strukturen oder IGBT-Bauelemente können durch die Anwendung der erfinderischen Technologie eine befruchtende Optimierung erfahren, um die Temperaturabhängigkeit der Parameter beispielsweise für einen Parallelbetrieb mehrere Leistungsschalterelemente zu verbessern.

Auch kann der Erfindungsgedanke für andere Einsatzzwecke von Halbleiterbauelementen sehr sinnvoll sein, wenn Effekte des dynamischen Avalanche zu reduzieren sind. In all den Fällen sind die Erkenntnisse dieser Erfindung übertragbar.

## Patentansprüche

1. Schnelle Leistungsdiode mit einem Halbleiterkörper, der eine Folge schichtförmiger Zonen aufweist, von welchen die mittlere hochohmige Schicht eine n⁻- Dotierung besitzt, der an der einen Seite mit einer hochdotierten n⁺- Dotierung versehen ist und der an der anderen Seite eine p⁺- Dotierung besitzt und dadurch einen pn- Übergang einschließt, bei dem die mittlere hochohmige n⁻- Zone durch Wahl der Dicke und Dotierkonzentration die definierte Sperrspannungsbelastbarkeit aufweist und bei dem der Halbleiterkörper, insbesondere die n⁻- Zone und der an der mittleren Zone angrenzende Teil der n⁺- Außenzone, mit zusätzlichen Rekombinationszentren versehen ist,
**dadurch gekennzeichnet, daß**
die schnelle Leistungsdiode als Freilaufdiode ein weiches Rückstromverhalten auch bei sehr steiler Kommutierung sowohl bei Raumtemperatur als auch bis hin zu 150°C aufweist und in der die Effekte des dynamischen Avalanche beherrscht werden, indem Rekombinationszentren in der mittleren n⁻- Zone und dem angrenzenden Teil der n⁺- Außenzone durch eine technologisch kombinierte Behandlung aus einer Platindiffusion und einer Elektronenbestrahlung erzeugt wurden, wobei der Beitrag der Elektronenbestrahlung an der Einstellung der Trägerlebensdauer der Minoritätsträger aus 20% bis 80% besteht.

2. Schnelle Leistungsdiode nach Anspruch 1,
**dadurch gekennzeichnet, daß**
die Platindiffusion und die Elektronenbestrahlung durch Einstellen ihrer Prozeßparameter je zur Hälfte an der Einstellung der Trägerlebensdauer der Minoritätsträger der schnellen Leistungsdiode beteiligt sind.

3. Schnelle Leistungsdiode nach Anspruch 1,
**dadurch gekennzeichnet, daß**
die n⁺- Schicht eine Eindringtiefe von größer 80µm aufweist, durch Diffusion erzeugt worden ist und damit ein flacher Gradient der Dotierstoffkonzentration am n/n⁺- Übergang besteht.

4. Schnelle Leistungsdiode nach Anspruch 1,
**dadurch gekennzeichnet, daß**
die n⁺- Schicht aus einem hochdotierten Substrat besteht und vor dem Übergang zur n⁻- Zone mindestes eine epitaxiale Zwischenschicht mit Dotierkonzentrationen, die zwischen den Konzentrationen der n⁻- Zone und der n⁺- Zone liegen, aufgebaut worden ist.

5. Schnelle Leistungsdiode nach Anspruch 1,
**dadurch gekennzeichnet, daß**
in der Nähe des p- Emitters durch Implantation von Protonen oder He⁺⁺- Ionen eine Zone niedrigerer Trägerlebensdauer erzeugt worden ist, welche ein weiches Abschaltverhalten bewirkt.

6. Verfahren zur Herstellung einer schnellen Leistungsdiode gemäß Anspruch 2,
**dadurch gekennzeichnet, daß**
die Platindiffusion bei einer Temperatur von 820°C bis 900°C und einer Zeit 30 min. unter reduzierender Atmosphäre durchgeführt wird.

7. Verfahren zur Herstellung einer schnellen Leistungsdiode gemäß Anspruch 2,
**dadurch gekennzeichnet, daß**
die Elektronenbestrahlung mit einer Energie zwischen 1 MeV und 8 MeV durchgeführt wird.

8. Verfahren zur Herstellung einer schnellen Leistungsdiode nach Anspruch 6,
**dadurch gekennzeichnet, daß**
die Elektronenbestrahlung als abschließende technologische und parameterbildende Maßnahme durchgeführt wird und der Halbleiterkörper durch thermische Behandlung bei Temperaturen zwischen 300°C und 400°C stabilisiert und alle Störstellen fixiert werden.

## Claims

1. Quick power diode with a semiconductor body comprising a series of layer-like zones of which the middle high-resistance layer has n⁻ doping which on one side is provided with highly doped n⁺ doping and which on the other side has p⁺ doping and hence encloses a p-n junction, in which the middle high-resistance n⁻ zone by selection of the thickness and doping concentration exhibits the predefined off-state voltage carrying capacity, and in which the semiconductor body, in particular the n⁻ zone and the portion of the n⁺ outer zone adjoining the middle zone, is provided with additional recombination centres, characterised in that the quick power diode as a recovery diode exhibits soft recovery behaviour even in case of very steep commutation both at room temperature and up to 150°C and in which the dynamic avalanche effects are controlled by producing recombination centres in the middle n⁻ zone and the adjoining portion of the n⁺ outer zone by technologically combined treatment consisting of platinum diffusion and electron irradiation, the contribution of electron irradiation to adjustment of the carrier life of the minority carriers consisting of 20% to 80%.

2. Quick power diode according to claim 1, characterised in that platinum diffusion and electron irradiation by adjustment of their process parameters participate half each in adjustment of the carrier life of the minority carriers of the quick power diode.

3. Quick power diode according to claim 1, characterised in that the n⁺ layer has a penetration depth of more than 80 µm and has been produced by diffusion and hence there is a flat gradient of dopant concentration at the n/n⁺ junction.

4. Quick power diode according to claim 1, characterised in that the n⁺ layer consists of a highly doped substrate, and before the junction with the n⁻ zone at least one epitaxial intermediate layer with doping concentrations which are between the concentrations of the n⁻ zone and the n⁺ zone has been built up.

5. Quick power diode according to claim 1, characterised in that in the vicinity of the p-emitter has been produced, by implantation of protons or He⁺⁺ ions, a zone of shorter carrier life which causes soft turn-off behaviour.

6. Method for the manufacture of a quick power diode according to claim 2, characterised in that platinum diffusion is carried out at a temperature of 820°C to 900°C for a time of 30 min in a reducing atmosphere.

7. Method for the manufacture of a quick power diode according to claim 2, characterised in that electron irradiation is carried out with energy of between 1 MeV and 8 MeV.

8. Method for the manufacture of a quick power diode according to claim 6, characterised in that electron irradiation is carried out as a final technological and parameter-forming measure and the semiconductor body is stabilised by heat treatment at temperatures of between 300°C and 400°C and all faults are fixed.

## Revendications

1. Diode de puissance rapide comportant un corps semi-conducteur doté d'une succession de zones se présentant sous forme de couches, parmi lesquelles la couche médiane fortement résistante comporte un dopage n⁻, lequel corps semi-conducteur est muni sur l'une de ses faces d'un fort dopage n⁺ et sur l'autre face d'un dopage p⁺, et de ce fait, inclut une jonction pn, dans lequel corps semi-conducteur la zone médiane n⁻ fortement résistante présente une capacité à supporter la tension de blocage définie par le choix de l'épaisseur et de la concentration de dopage et dans lequel le corps semi-conducteur, en particulier la zone n⁻ et la partie de la zone extérieure n⁺ jouxtant la zone médiane sont munies de centres de recombinaison supplémentaires,
caractérisée en ce que
la diode de puissance rapide présente, en tant que diode « roue libre », un comportement doux en ce qui concerne le courant de retour, même dans le cas de commutations à forte pente aussi bien à température ambiante qu'également à une température allant jusqu'à 150°C, et dans laquelle les effets de l'avalanche dynamique sont maîtrisés, les centres de recombinaison de la zone médiane n⁻ et de la partie voisine de la zone extérieure n⁺ étant réalisés au moyen d'un traitement techniquement combiné consistant en une diffusion de platine et en une exposition au bombardement d'électrons, l'exposition au bombardement d'électrons contribuant à la détermination de la durée de vie des porteurs minoritaires pour 20 à 80 %.

2. Diode de puissance rapide selon la revendication 1,
caractérisée en ce que
la diffusion de platine et l'exposition au bombardement d'électrons participent, chacune pour moitié, grâce au choix de leurs paramètres de processus, à la détermination de la durée de vie des porteurs minoritaires de la diode de puissance rapide.

3. Diode de puissance rapide selon la revendication 1,
caractérisée en ce que
la couche n⁺ présente une profondeur de pénétration supérieure à 80 µm et a été réalisée par diffusion, et en ce que, de ce fait, il y a un gradient plat de la concentration en matériau de dopage à la jonction n/n⁺.

4. Diode de puissance rapide selon la revendication 1,
caractérisée en ce que
la couche n⁺ est constituée d'un substrat fortement dopé et en ce qu'avant la transition vers la zone n⁻ au moins une couche intermédiaire épitaxiale a été constituée, avec des concentrations de dopage qui se situent entre la concentration de la zone n⁻ et celle de la zone n⁺.

5. Diode de puissance rapide selon la revendication 1,
caractérisée en ce qu'
à proximité de l'émetteur du type p, une zone de plus faible durée de vie des porteurs a été réalisée par implantation de protons ou d'ions He⁺⁺, laquelle provoque un comportement de coupure doux.

6. Procédé de fabrication d'une diode de puissance rapide selon la revendication 2,
caractérisé en ce que
la diffusion de platine est exécutée à une température de 820°C à 900°C pendant un temps de 30 mn, sous atmosphère réductrice.

7. Procédé de fabrication d'une diode de puissance rapide selon la revendication 2,
caractérisé en ce que
l'exposition au bombardement d'électrons est réalisée avec une énergie comprise entre 1 MeV et 8 MeV.

8. Procédé de fabrication d'une diode de puissance rapide selon la revendication 6,
caractérisé en ce que
l'exposition au bombardement d'électrons est exécutée en tant que mesure technologique finale servant à la détermination des paramètres, et en ce que le corps semi-conducteur est stabilisé par traitement thermique à des températures comprises entre 300°C et 400°C, et que toutes les imperfections sont fixées.
